# EUROPEAN PATENT APPLICATION

(11) **EP 4 847 936 A1**
(43) Date of publication of application: **02.12.2026**
(21) Application number: 25178864.2
(22) Date of filing: 26.05.2025
(51) Int. Cl.: G01R 33/56, G06T 5/70, G01R 33/561

(54) **NOISE CONTROL IN MAGNETIC RESONANCE IMAGE RECONSTRUCTION**

(71) Applicant: Koninklijke Philips N.V., 5656 AE Eindhoven (NL)
(72) Inventor: VAN GEMERT, Jeroen, Eindhoven (NL); KOOLSTRA, Kirsten, Eindhoven (NL); DE WEERDT, Elwin, 5656 AG Eindhoven (NL)
(74) Representative: Philips Intellectual Property & Standards

(57) **Abstract**

Methods and systems for imaging at least a part of a body are presented. The method comprises: receiving (204) k-space measurement data obtained by subjecting the portion of the body (10) to a magnetic resonance imaging protocol; generating (206) a first image based on the k-space measurement data, wherein the first image is denoised by a first denoiser stage; generating (208) a second image by inputting the first image to a second denoiser stage, which further denoises the first image; providing (210) a user selectable denoising level; adjusting denoising levels of the second denoiser stage and the first denoiser stage such that the combination of the denoising levels follows a monotonic function of user selectable denoising level between two endpoints of a range associated with full denoising and no denoising. The system comprises a computational system configured to perform the method.

## Description

### FIELD OF THE INVENTION

The invention relates to the field of magnetic resonance imaging. It concerns a method of controlling noise level in magnetic resonance imaging, a magnetic resonance imaging system and a computer program for a magnetic resonance imaging system.

### BACKGROUND OF THE INVENTION

Image-forming magnetic resonance (MR) methods that utilize the interaction between magnetic fields and nuclear spins in order to form two-dimensional or three-dimensional images are widely used nowadays, notably in the field of medical diagnostics, due to their superiority for imaging soft tissue to other imaging methods, mainly because of not requiring ionizing radiation and being usually not invasive.

In some medical applications, the difference in MR signal intensity from standard magnetic resonance imaging (MRI) protocols, i.e. the contrast between different tissues, might not be sufficient to obtain satisfactory clinical information.

US12175636 B2 discloses a method of altering noise level in magnetic resonance image reconstruction of an object. A first reconstruction or representation is provided as one extreme of the range which is considered noisy. This first representation is the extreme end of a range to be provided for selectable levels of noise. Through a machine-learned denoising network an altered representation is generated, having less noise in response to the input that is the first representation. This alteration creates the other extreme of the range. A user selected level of noise level that is between the two extremes of the range is then provided, based on which the first representation and the altered representation are combined in response to the user inputting a desired relative amount of noise.

### SUMMARY OF THE INVENTION

An object of the invention is to provide an improved MR imaging method and an MRI system enabling robust and predictable noise behavior in reconstructed images at any requested denoising level.

In accordance with the invention, a method of MR imaging of at least a portion of a body is provided, comprising:
receiving k-space measurement data obtained by subjecting the portion of the body to a magnetic resonance imaging protocol;
generating a first image based on the k-space measurement data, wherein the first image is denoised by a first denoiser stage;
generating a second image by inputting the first image to a second denoiser stage, which further denoises the first image;
providing a user selectable denoising level;
adjusting denoising levels of the second denoiser stage and the first denoiser stage such that the combination of the denoising levels follows a monotonic function of user selectable denoising level between two endpoints of a range associated with full denoising and no denoising.

The combination of the denoising levels of the multiple denoiser stages is realized such that the denoising level of the second denoiser stage influences the denoising level of the first denoiser stage.

In some embodiment the monotonic function may follow approximately a linear scale. According to some embodiments the first image may be generated by a regularized reconstruction algorithm, which comprises the first denoiser stage. The regularized reconstruction algorithm may be based on any of sensitivity encoding (SENSE), generalized auto calibrating partially parallel acquisitions (GRAPPA), and compressed SENSE (CS-SENSE) protocols.

According to some embodiments the second denoiser stage may be a machine-learning model. The method may further comprise displaying a graphical representation of denoising levels to the user through which the user is allowed to select a desired denoising level in the interval between the two endpoints.

In some embodiments the user may be allowed to input a desired denoising level through a tab by typing in the denoising level or by selecting the desired denoising level from a predefined number of discrete denoising levels, wherein the predefined number of discrete denoising levels may comprise several selectable textual information, e.g., no denoising, weak denoising, medium denoising, strong denoising, and maximal denoising, each associated with respective numerical denoising levels in the interval between the two endpoints.

In some embodiments the method comprises outputting the second image to a display. In some examples, the method may further comprise displaying an image corresponding to full denoising and an image corresponding to no denoising.

The method of the invention described thus far can be carried out by means of an MRI system including at least one main magnet coil for generating a uniform steady magnetic field within an examination volume, a number of gradient coils for generating switched magnetic field gradients in different spatial directions within the examination volume, at least one radiofrequency (RF) coil for generating RF pulses within the examination volume and/or for receiving MR signals from the body of a patient positioned in the examination volume, a control unit for controlling the temporal succession of RF pulses and switched magnetic field gradients, and a reconstruction unit for reconstruction of an MR image from the received MR signals. The method of the invention is preferably implemented by a corresponding programming of the control unit and/or the reconstruction unit of the MRI system. In some embodiments the method further comprises outputting the magnetic resonance images to a display screen, which may be included in the MRI system or it may be any peripheral display such as tablet screen, smartphone.

Any of the embodiments of the method according to the invention can be advantageously carried out by a system in most MR environments in clinical use at present. To this end it is merely necessary to utilize a computer program by which a computational system (e.g., a PC) is instructed to control a magnetic resonance imaging system and to perform any of the method embodiments of the invention. The computer program may be present either on a data carrier or may be present in a data network so as to be downloaded for installation, e.g., into the control unit or the reconstruction unit of an MR system.

### BRIEF DESCRIPTION OF THE DRAWINGS

The enclosed drawings disclose preferred embodiments of the present invention. It should be understood that the drawings are for the purpose of illustration only and not as a definition of the limits of the invention. In the drawings:
Figure 1 shows an MR system according to the invention;
Figure 2 shows a flow chart illustrating a method according to the invention;
Figure 3 shows an example of a display layout for presenting information according to the invention;
Figure 4 shows images according to an example of the invention.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system may be implemented in a computer implemented method and/or in a computer program product, in a corresponding manner.

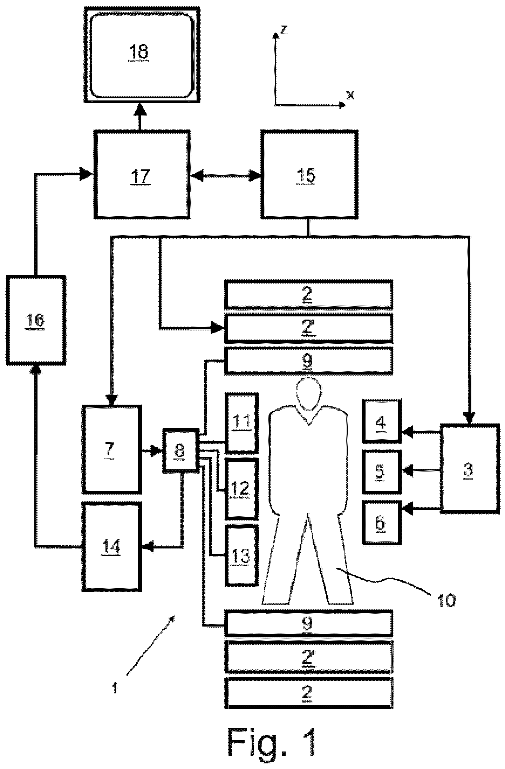

With reference to Figure 1, an MRI system 1 is shown. The device comprises superconducting or resistive main magnet coils 2 located such that a substantially uniform, temporally constant main magnetic field B₀ is created along a longitudinal z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 provides current pulses to selected ones of whole-body gradient coils 4, 5 and 6 along *x*, *y* and *z*-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments which, together with any applied magnetic field gradients, achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the body RF coil 9. The MR imaging sequences or protocols may be stored in a memory. The memory is intended to represent any combination of memory or storage device which is accessible to a computational system configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and are demodulated by a receiver 14, preferably including a preamplifier (not shown). The receiver 14 is connected to the RF coils 9, 11, 12 and 13 via send/receive switch 8.

The RF body coil or other segmented coils, such as the local array RF coils may comprise multiple RF transmission channels. They may use a special configuration with different transmission channel settings for RF saturation and imaging RF pulses.

A computer system or with other words a host computer 15 controls the shimming coils 2' as well as the gradient pulse amplifier 3 and the transmitter 7 to generate any of a plurality of MR imaging protocols, such as echo planar imaging, echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. The digital raw image data may be stored in the memory. In some MR devices the data acquisition system 16 is a separate computer, which is specially configured for acquisition of raw image data.

The digital raw image data is used for generating or reconstructing an image representation by a reconstruction processor 17, which applies a Fourier transform to the digital raw data and/or other appropriate reconstruction algorithms, such as parallel imaging techniques, e.g., SENSE, GRAPPA, and CS-SENSE. Generating the MR image can be based on algorithms stored in cloud-based memory, to which the raw image data is transmitted and the cloud-based computing system may perform the image reconstruction. The MR image is then transmitted back to the MRI system. The MR image may represent a planar slice through the patient, an array of parallel planar slices, a three-dimensional volume, or the like. The MR image may then be stored in a memory where it may be accessed for converting slices, projections, or other portions of the image representation into appropriate format for visualization on a display screen 18 for presenting the information in user-readable manner. In some embodiments the functionalities of the host computer, the data acquisition system and the reconstruction processor are implemented in one computational system.

The computational system or any of the host computer, the data acquisition system and the reconstruction processor may be in further communication with at least one user interface (UI) that for example, enables an operator or user to control various functionalities of the respective modules and/or the operation of the MRI system, for example by using one or more peripherals.

The user interface as used herein is an interface which allows a user or operator to interact with a computer or computational system. A user interface may also be referred to as a human interface device. A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, touchscreen, graphics tablet, joystick, gamepad, webcam, headset, pedals, wired glove, remote control, and accelerometer are all examples of user interface components, which enable receiving information or data from an operator.

Without limitation by any of the features disclosed with reference to Figure 1, the MRI system may comprise any further elements that allow use of any of the methods disclosed in US12175636 B2, which is incorporated herein by reference in its entirety.

In advanced magnetic resonance imaging, k-space data is acquired with several coils. The data from the individual channels associated with the respective coils is combined using parallel imaging techniques, such as SENSE, GRAPPA and CS-SENSE. The latter technique is one of multiple sparsity-based techniques. Techniques that have similar behavior are disclosed in Lustig M, Pauly JM, "SPIRiT: Iterative self-consistent parallel imaging reconstruction from arbitrary k-space", Magn Reson Med. 2010; 64(2):457-71, doi:10.1002/mrm.22428 and Sriram A, et al., "GrappaNet: Combining Parallel Imaging With Deep Learning for Multi-Coil MRI Reconstruction", 2020 IEEE/CVF Conference on Computer Vision and Pattern Recognition (CVPR); doi: 10.48550/arXiv.1910.12325, which are hereby incorporated by reference in their entirety. CS-SENSE uses an additional wavelet regularization term compared to SENSE, which regularization term allows one to control the smoothness in the image, hence, it acts as a denoiser. The wavelet in return is also used to suppress the g-factor behavior, i.e. noise blow-up while converging, typically encountered in magnetic resonance imaging when accelerating the acquisition. Although parallel imaging technique (using e.g., wavelets) acts as a denoiser, the level of denoising can further be improved by a second denoiser algorithm, e.g., using deep learning. The invention discloses a method in which a first denoiser (e.g., a wavelet-based denoiser) and a second denoiser (e.g., a deep learning based denoiser) are combined into a solution that provides an overall improved image denoising behavior.

The challenge with image denoising using multiple denoising steps is that the denoising level set by the user through the user interface of the MRI system should consistently produce the desired overall denoising behavior, and by that one must balance the strength of the two denoisers acting in subsequent stages. Ideally, maximal denoising should remove all the noise from the image, while medium denoising (50%) should remove half of the noise. This should be the case for all protocols, anatomies, and signal to noise ratios (SNR). According to the invention, denoising level of the first denoiser stage is made dependent on the denoising level of the second denoiser stage to achieve the desired behavior.

Through the UI of the MRI system the user may select discretely defined denoising levels such as no denoising, weak denoising, medium denoising, strong denoising, and maximal denoising, which discrete denoising levels have associated percentage of noise to be removed from the images. Alternatively or additionally, the level of denoising may be defined by the user through a slider or through any suitable graphical solution, wherein any value between 0% and 100% denoising level is selectable.

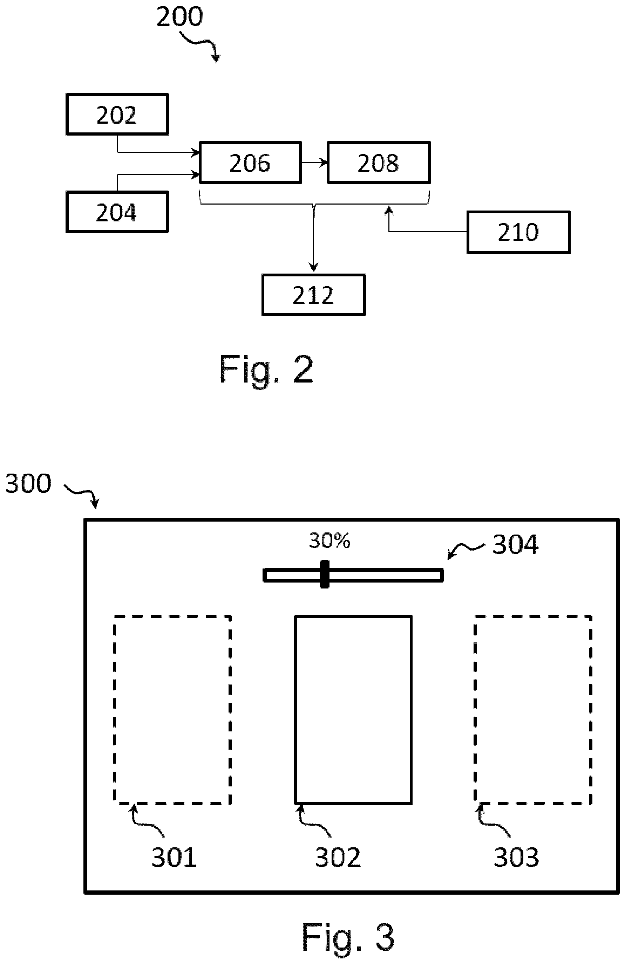

With reference to Figure 2, a flow chart illustrates an exemplary method 200 according to the invention. In step 202 the coil sensitivity maps are provided and in step 204 the raw k-space measurement data are acquired, which are inputs to step 206 in which images are generated based on CS-SENSE reconstruction algorithm or any other parallel imaging technique having a denoising function.

The wavelet is incorporated in the CS-SENSE optimization problem as ${p}^{˜} = {min}_{p} {\left‖Ep-y\right‖}_{2}^{2} + λ \left‖Rp\right‖ + γ \left|Wp\right|$ (Eq. 1) where *E* is the encoding matrix, *p* is the image, *y* are the k-space measurements, *R* is the QBC-regularization, and *W* is the sparsity-constraint, i.e. the wavelet regularization. The amount of denoising in this first denoiser stage is determined by the regularization parameter *γ*. The exact value depends on the denoising_level parameter that is set by the user: $γ = α * denoising_level$ (Eq. 2)

The level of *α* can be empirically tuned and may be set to a fixed value. A setting for *α* of about 20% results in an image that is denoised weakly and has enough 'power' to mitigate the g-factor behavior typically encountered for no denoising (i.e. 0%). Furthermore, having a denoising level of 0% also disables the denoising for the Nesterov scheme, according to Eq. 1. Linear weighting is preferably used to determine *γ* such that the user experiences continuous or quasi-continuous behavior when selecting the user-defined denoising level option. Other values for *α* may be contemplated, for example in the range of 15-25% for various clinical applications where the empirically tuned level of *α* supports a deviation from the provided example.

After optimization based on coil combination an estimated image reconstruction *p̃* is obtained.

The second denoiser stage illustrated by step 208, may for instance comprise or be performed by a deep learning model, in which image *p̃* that has weakly been denoised in the first denoiser stage, is further denoised according to $\hat{p} = D \left\{{p}^{˜}\right\}$ (Eq. 3)

Using the output of the second denoiser stage and that of the first denoiser stage, one can compute the noise removed by the second denoiser stage: $noise = {p}^{˜} - D \left\{{p}^{˜}\right\}$ (Eq. 4)

Subsequently, in step 210 the user selects a desired denoising level, and only a fraction of the noise is removed in the second denoiser stage based on the denoising level set by the user $\hat{p} = {p}^{˜} - denoising_level ∗ noise$ (Eq. 5) whereas the denoising levels of the first denoiser stage and second denoiser stage are balanced, for example based on Eq. 2.

In the example of the second denoiser being a deep learning model, the deep learning network comprises of a sequence of convolution and Leaky ReLu layers. By using convolutional layers, each pixel in the output image represents the weighted average of a small neighborhood of this pixel in the input image (receptive field). The effective weighting function is the combined result of the individual convolutional layers and activation functions of the network. Its shape is adapting to local image properties in a non-linear way, which is controlled by how the network has been trained. The size of receptive field is fixed by design in view of kernel size and number of layers. A wide variety of network architectures can be used to create denoising models, for example, disclosed in Nahida Nazir et al., "Recent developments in denoising medical images using deep learning: An overview of models, techniques, and challenges", Micron, Volume 180, 2024, 103615, which is hereby incorporated by reference in its entirety (https://doi.org/10.1016/j.micron.2024.103615). Models are typically trained using training data pairs, where each one consists of a noisy input image and a noise-free target image. Models can be trained for a fixed number of training iterations or based on a predetermine stopping condition such as a performance threshold. During inference, an MR image, containing noise, is sent through the trained artificial intelligence (AI) or machine-learning model.

In essence, the denoising level selected by the user adjusts the denoising levels of the second denoiser stage and the first denoiser stage such that the combination of the denoising levels of the two stages is conforming to a monotonically increasing or decreasing function (e.g., a linear scale) of user selectable denoising level between two endpoints of the range associated with full denoising and no denoising. With other words, the denoising level of the first denoiser is dependent on the denoising level of the second denoiser. This is realized by setting the denoising level of the first denoiser to, for example, a linearly weighting version of the denoising level selected by the user, as defined in Eq. 2. This means that the strength of the first denoiser gradually increases from 0% to *α*% as the user-selected denoising level increases from 0 to 100%. The second denoiser will receive an image that is slightly more denoised for higher values of the user-selected denoising level. With this denoising level relationship, the second denoiser receives data that contains minimal g-factor and noise coloring effects, while at the same time it is possible to reach effective denoising levels as low as 0%.

In some examples a certain deviation from a chosen function for user selectable denoising level, e.g., according to a linear scale, may be tolerated, in case that the combination of the two denoiser stages provides a reproducible and consistent deviation, which conforms to the monotonically increasing function. A maximum deviation may be set for example to any of the following, 1%, 5%, 10%. In some of the embodiments the maximum deviation may be set locally for specific values of the denoising scale.

The image denoised according to the user selected denoising level is output in step 212 either to a peripheral, such as for example a screen display 18, or to further processing for preparation of a user-intelligible information, for example in a standardized color scale suitable for specific clinical applications.

Figure 3 illustrates an example layout 300 for displaying the magnetic resonance image denoised according to the invention. In the exemplary layout, the user is permitted to select a level of denoising through a slider 300 and the image 302 denoised according to the selected denoising level is presented on the display screen. Additionally, any of the images according to the two end values of the selectable range may be presented to the user, e.g., fully denoised 303 and reconstruction purely from raw data (i.e. no denoising at all 301), and the user may be permitted to disable presentation of these images at any point in time.

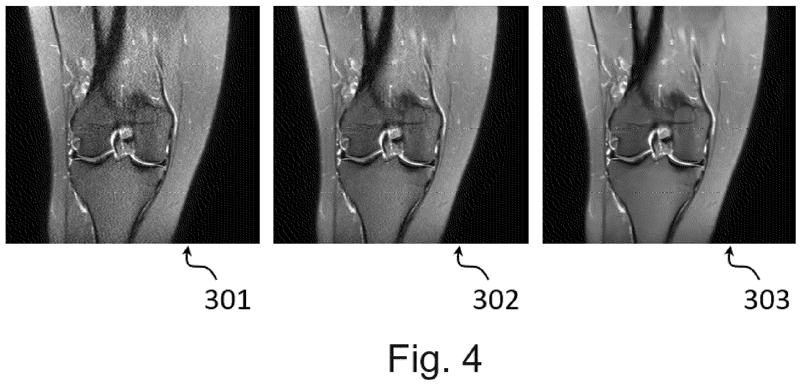

In Figure 4 images of an example according to the invention are presented with further reference to the exemplary layout of Figure 3. The fully denoised image 303 and the image reconstructed purely from raw data 301, i.e. no denoising at all, are illustrated on both sides of the image 302 denoised at 30% according to the selected denoising level, for example through slider 304 in Figure 3.

The present invention has several benefits: (1) denoising may be controlled reliably e.g., in linear way, meaning that the user archives highly reproducible denoising upon denoising level selection, denoising with 25% implies that 25% of the noise removed, whereas 50% implies that 50% is removed; (2) there are no assumptions or estimates required on the signal to noise ratio of a scan, making the denoising robust and predictable for the user; (3) setting a denoising level of 0% gives 0% denoising, while for 100% denoising, the exact value for the first coil combination part (Nesterov, Eq. 1) is not significant, as it is aimed for a fully denoised image.

The invention is applicable for any multi-dimensional (e.g., 2D and 3D) magnetic resonance image reconstruction.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

## Claims

1. A method (200) of imaging at least a portion of a body (10), comprising:
receiving (204) k-space measurement data obtained by subjecting the portion of the body (10) to a magnetic resonance imaging protocol;
generating (206) a first image based on the k-space measurement data, wherein the first image is denoised by a first denoiser stage;
generating (208) a second image by inputting the first image to a second denoiser stage, which further denoises the first image;
providing (210) a user selectable denoising level;
adjusting denoising levels of the second denoiser stage and the first denoiser stage such that the combination of the denoising levels follows a monotonic function of user selectable denoising level between two endpoints of a range associated with full denoising and no denoising.

2. The method of claim 1, wherein the monotonic function follows approximately a linear scale.

3. The method of claim 1 or 2, wherein the denoising level of the second denoiser stage influences the denoising level of the first denoiser stage.

4. The method of any of the preceding claims, wherein the first image is generated by a regularized reconstruction algorithm, which comprises the first denoiser stage.

5. The method of claim 4, wherein the regularized reconstruction algorithm is based on a compressed SENSE reconstruction protocol.

6. The method of any of the preceding claims, wherein the second denoiser stage comprises a machine-learning model.

7. The method of any of the preceding claims, further comprising:
displaying a graphical representation (304) of denoising levels to the user through which the user is allowed to select a desired denoising level in between the two endpoints.

8. The method of any of claims 1 to 6, further comprising:
displaying a tab wherein the user is allowed to input a desired denoising level.

9. The method of any of claims 1 to 6, further comprising:
displaying a graphical representation of a predefined number of discrete denoising levels to the user through which the user is allowed to select the denoising level.

10. The method of claim 9, wherein the predefined number of discrete denoising levels comprises several selectable textual information, each associated with respective distinct denoising level.

11. The method of any of the preceding claims, further comprising:
outputting (212) the second image (302) to a display (18).

12. The method of claim 11, further comprising:
outputting to the display an image (303) corresponding to full denoising and an image (301) corresponding to no denoising.

13. A medical system (1) comprising a computational system (15, 16, 17) configured to perform a method according to any of the claims 1 to 12.

14. The medical system of claim 13, further comprising a magnetic resonance imaging system.

15. A computer program comprising machine executable instructions, wherein execution of the machine executable instructions causes a computational system to perform a method according to any of the claims 1 to 12.
